# EUROPEAN PATENT APPLICATION

(11) **EP 2 738 828 A2**
(43) Date of publication of application: **04.06.2014**
(21) Application number: 13187668.2
(22) Date of filing: 08.10.2013
(51) Int. Cl.: H01L 49/02, H01L 23/522

(54) **MIM-capacitor and method of manufacturing same**

(30) Priority: 28.11.2012 US 201213687842
(71) Applicant: NXP B.V., 5656 AG Eindhoven (NL)
(72) Inventor: Daamen, Roel, Redhill, Surrey RH1 1SH (GB); Koops, Gerhard, Redhill, Surrey RH1 1SH (GB); Steeneken, Peter, Redhill, Surrey RH1 1SH (GB)
(74) Representative: Schouten, Marcus Maria

(57) **Abstract**

An integrated circuit includes a support (1), at least three metal layers above the support, the metal layers having a top metal layer with a top plate (33) and a bottom metal layer with a bottom plate (25), dielectric material (31) between the top and bottom plates to form a capacitor (2), and plural oxide layers (9, 11, 13, 15) above the support, such oxide layers including a top oxide layer (27), each oxide layer respectively covering a corresponding metal layer. The top oxide layer covers the top metal layer and has an opening exposing at least part of the top plate. A method of forming the integrated circuit comprises the steps of providing a support with metal and oxide layers, including a bottom plate, forming a cavity exposing the bottom plate, filling the cavity with dielectric, applying a further metal layer having a top plate and a further oxide layer, and forming an opening to expose the top plate.

## Description

### FIELD OF THE INVENTION

Aspects of the present disclosure relate to apparatuses, devices, and methods involving integrated capacitors. Such capacitors are suited for use in automotive applications, including automotive isolator devices, which are components that allow the safe transmission of electrical signals between different voltage domains. Devices meant for automotive use must be robust and stable, since automotive service can be demanding, passengers and electronics must be protected, and the operating environment can be harsh.

Various techniques can be used to isolate electrical circuits; optical, inductive and capacitive isolation schemes are known. Capacitive isolation is particularly well-suited to automotive service.

More specifically, many automotive applications for electric and hybrid vehicles (electrically driven vehicles) require a high-voltage signal isolator, which can be integrated on a chip. The isolator can be of either single chip or multi-chip design. This invention is directed to an easy to integrate high-voltage capacitor suitable for use in such automotive isolator applications. This invention is not intended to be limited just to such applications, however, and can be employed anywhere there is electrical signaling across different voltage domains, such as in marine and aviation applications.

For example, signal circuits may be galvanically isolated from one another using capacitive coupling on signal paths between the circuits. As a result of such isolation, the circuits operate in separate voltage domains that are not referenced to one another by a common ground voltage level. Consequently, large voltage differences may arise between the different voltage domains. Galvanic isolation has been used for signaling between such different voltage domains in a variety of different applications. For instance, galvanic isolation can be provided between multiple integrated circuit chips, which can be located within the same package or in different packages. Signals can be passed between the integrated circuits using galvanic isolation techniques.

One method of galvanic isolation uses capacitors in the signal paths between two circuits to block DC voltages and attenuate low-frequency signals while transmitting highfrequency signals. Such capacitors can be part of the integrated circuit, with the capacitor plates being formed in the Metal-1 to Metal-5 (or Metal-6) levels of the integrated circuit fabrication process and the capacitor dielectric being formed as part of the insulating levels between the Metal-1 to Metal-5 layers (dielectrics below the Metal-1 layer are not strong enough to sustain the high voltages which may be encountered). However, in a CMOS backend, the dielectric used is optimized for low capacitance, which compromises breakdown strength.

Two-channel, bidirectional dual-die isolators are known which employ MIM-capacitors to provide the desired signal isolation.

Due to the nature of the IC fabrication process, a large number of dielectric interfaces are typically present between the Metal-1 and top metal (e.g. Metal-5) layers (the specific number of metal layers is exemplary, and it will be understood that the same issues arise regardless of the number of layers involved). Such dielectric interfaces could create possible reliability concerns for long term operation of device having an interlayer capacitor.

While is it known to form capacitors within the layers of an IC device, the materials and configurations available in the IC fabrication process (for example, CMOS), means that such integrated capacitors have relatively low breakdown voltages. Also, physical space constraints may make it difficult to implement capacitors having the required breakdown voltage in the fabricated ICs.

For example, a parallel plate capacitor may be implemented alongside other circuitry in an integrated circuit (IC) made using conventional processes for fabricating ICs with multiple internal metal layers (e.g., CMOS processing). The term "metal layer", it will be understood, does not require an unbroken metal region, rather, it encompasses a planar region of patterned metal (e.g., wiring lines which electrically connect various devices in an IC can be formed by one or more metal layers, possibly connected by inter-layer vias). Two capacitor plates are respectively implemented in different metallization layers of the IC and are separated by a dielectric layer. The breakdown voltage of the resulting parallel plate capacitor is in part dependent upon the thickness of the dielectric layer. For higher voltage applications, the thickness of the dielectric layer can be increased to provide a higher breakdown voltage. However, there are limits to how thick the dielectric layer can be made; in some CMOS processes, the maximum dielectric thickness that can be achieved is about 5-10 microns. For some applications, this dielectric thickness is not sufficient to provide a capacitor possessing the breakdown voltage required for satisfactory operation.

Since large voltage differences may arise between isolated voltage domains for some applications (e.g., automotive applications), possibly on the order of several kilovolts for transients, it is desirable to increase the breakdown voltage of MIM-capacitors which are fabricated with IC manufacturing techniques for use in isolator devices.

### SUMMARY OF THE INVENTION

This invention, in contrast to what is known, allows use of a dielectric material with optimized properties and higher electrical breakdown strength to be used when forming a MIM-capacitor in an integrated circuit.

This invention involves an integrated circuit, having a support, at least three metal layers arranged above the support, the metal layers including a top metal layer having a top plate and a bottom metal layer having bottom plate, a dielectric material disposed between the top and bottom plates so as to form a capacitor, and plural oxide layers arranged above the support, the layers including a top oxide layer, each oxide layer respectively covering a corresponding metal layer. The top oxide layer covers the top metal layer and the top oxide layer has an opening through which at least a portion of the top plate is exposed.

Such an integrated circuit can also include a passivation layer covering the top oxide layer, the passivation layer having an opening through which the portion of the top plate is exposed.

Additionally, in such an integrated circuit, the top metal layer can be the topmost metal layer and the bottom metal layer can be the metal-1 layer of a CMOS N-metal structure, N being the number of metal layers.

The integrated circuit can be such that the top metal layer is the topmost metal layer and the bottom metal layer is the bottommost metal layer of a BiCMOS device structure or a bipolar device structure.

The integrated circuit can have at least one of the following conditions satisfied: the dielectric material has a different composition than the oxide layers; the dielectric material is continuous without multiple interfaces; and the dielectric material has an electrical breakdown strength that is greater than an electrical breakdown strength of each of the oxide layers.

The integrated circuit also can have a silicon-on-insulator layer arranged above the buried oxide layer, and, optionally, at least one of a shallow trench isolation element and a medium trench isolation element arranged in the silicon-on-insulator layer.

In the integrated circuit, a top portion of the dielectric material can abut the top plate, and, in overhead projection view, the abutting top portion of the dielectric material extends beyond the top plate.

In the integrated circuit, a bottom portion of the dielectric material can abut the bottom plate, and, in overhead projection view, the bottom plate projects beyond the abutting bottom portion of the dielectric material.

A method of forming a MIM-capacitor in an integrated circuit includes the steps of providing a workpiece having a support, at least three metal layers arranged above the support, the metal layers including a bottom metal layer having bottom plate, and a plurality of oxide layers arranged above the support, the oxide layers including a top oxide layer, each oxide layer respectively covering a corresponding metal layer, forming a cavity through the metal and oxide layers to expose the bottom plate, and filling the cavity with dielectric material. This method also involves applying a further metal layer above the cavity, the further metal layer including a top plate which contacts the dielectric material, forming a further oxide layer on the further metal layer, and forming an opening through the further oxide layer and the further metal layer to expose the top plate.

This method can include the step of providing a passivation layer on the further oxide layer prior to the step of forming the opening, wherein the opening is also formed through the passivation layer.

Additionally, the method can include, after the step of filling the cavity with dielectric material, a step of planarizing the dielectric material. Such planarizing can be performed by CMP.

In this method the step of forming the cavity can involve masking and then dry etching.

The step of forming the opening can involve masking and then dry etching.

The method can also include the step of attaching an electric conductor to the exposed top plate.

The method can be performed as part of a CMOS N-metal process, N being the number of metal layers formed.

In the method, the further metal layer can be the topmost metal layer and the bottom metal layer can be the bottommost metal layer, the further metal layer and the bottom metal layer being formed in a BiCMOS process or a bipolar process.

In the method, a top portion of the dielectric material can abut the top plate, and, in overhead projection view, the abutting top portion of the dielectric material extends beyond the top plate.

In the method, a bottom portion of the dielectric material can abut the bottom plate, and, in overhead projection view, the bottom plate projects beyond the abutting bottom portion of the dielectric material.

### BRIEF DESCRIPTION OF THE DRAWINGS

The invention will be described in greater detail hereinafter with reference to example embodiments depicted in the accompanying drawings, described below, and which are illustrative and to which the invention is not limited.
Figure 1 is a side cross-sectional view of a MIM-capacitor prepared in accordance with this invention;
Figure 2 is a partially-finished substrate to be processed in accordance with this invention to obtain the MIM-capacitor of Figure 1;
Figures 3-7 are side cross-sectional views showing various steps by which the substrate of Fig. 2 is formed into the MIM-capacitor of Figure 1; and
Figure 8 is a flowchart depicting a method for manufacturing a MIM-capacitor.

### DETAILED DESCRIPTION OF EXEMPLARY EMBODIMENTS

The present invention seeks to increase the vertical breakdown voltage of a MIM-capacitor formed in an IC device during back-end-of-line processing. This is done by providing the MIM-capacitor in a cavity between the metal-1 and top metal (metal-N) layers of the IC. To do this, a cavity is formed in the partially-completed IC device, and the MIM-capacitor is then assembled in that cavity.

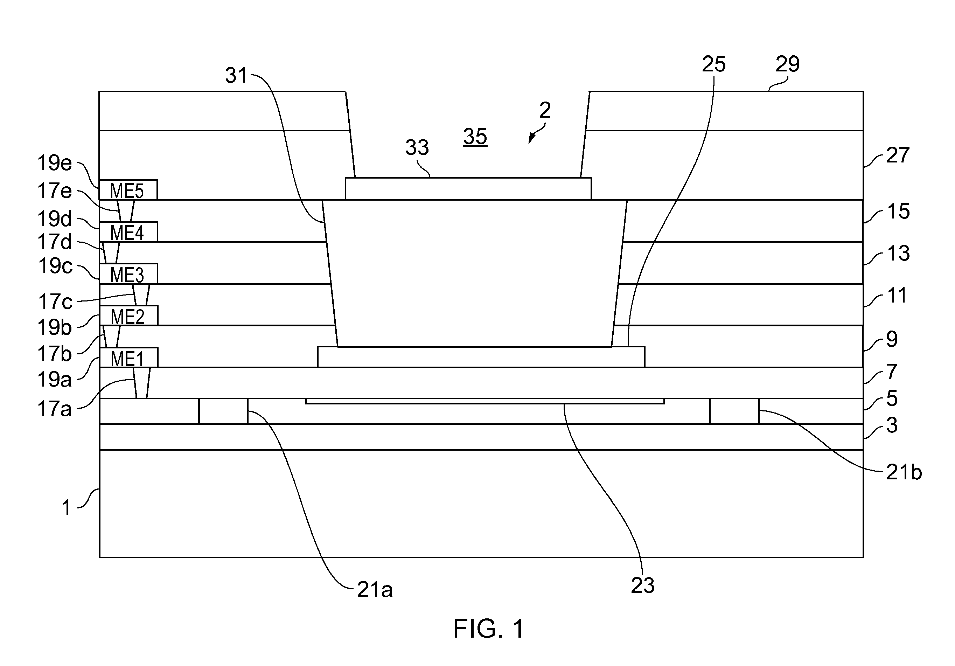

Figure 1 depicts a MIM-capacitor 2 constructed in accordance with one embodiment of this invention. MIM-capacitor 2 includes a layer of dielectric material 31 arranged between a top plate 33 and bottom plate 25, and the dielectric material 31 is preferably optimized for electrical breakdown strength. By way of non-limiting example, it may be preferred to use high-breakdown quality SiO₂ as the dielectric material. Other high quality dielectric materials such as Ta₂O₅, ZrO₂, RuO₂ and organic polymers also could be used, as can suitable dielectric materials discovered hereafter. As shown, the MIM-capacitor 2 is part of and is embedded within a multi-layer integrated circuit (IC) structure provided on handle wafer 1, and is substantially thicker than any of the individual oxide layers 9, 11, 13, 15 that are also present.

Thus, it may be preferable for the dielectric material 31 to have a different composition than the oxide layers 9, 11, 13 and 15 (alternatively the same material could be used).

One benefit to the structure depicted in Fig. 1 is that the dielectric material 31 has no interfaces - it is continuous. This avoids the problems with having multiple interfaces, discussed above.

Preferably, the electrical breakdown strength of the dielectric material 31 is greater than that of the other dielectric layers on the device (oxide layers 9, 11, 13, 15).

The aspects mentioned in the previous three paragraphs can improve the reliability of the MIM-capacitor 2, and preferably (but not necessarily) these aspects can be used together.

The multi-layer IC structure shown in Fig. 1 can be formed by a 5-metal CMOS process such as that which is known. In such a CMOS process, a buried oxide layer (BOX) 3 is formed on the handle wafer 1, the handle wafer 1 serving as a support. A silicon-on-insulator substrate (SOI) 5 is then formed on the BOX layer 3. Using known masking and etching techniques, medium trench isolation (MTI) elements 21a, 21b are formed to extend through the SOI substrate 5 to the BOX layer 3, and a shallow trench isolation element 23 is formed on the SOI substrate 5, between the MTI elements 21a, 21b. The use of MTI and STI elements is itself well-known, as described in U.S. patent no. 7,884,440, for example.

Another Buried Oxide Layer (BOX) 7 is arranged above the SOI substrate 5, MTI elements 21a, 21b, and STI element 23.

Together, the use of the STI element 23 and the BOX layers 3 and 7 helps to reduce parasitic capacitances.

The metal-1 layer structures, which includes metal-1 layer element 19a and bottom plate 25 (and possibly, additional structures such as connect lines, not shown), is arranged on the BOX layer 7, and the metal-1 layer element 19a is in electrical communication with+ SOI substrate 5 through via 17, formed in BOX layer 7. The metal-1 layer structures are covered by oxide layer 9. Bottom plate 25 is preferably connected to other components of the IC. Such connection can be made by suitable patterning of the metal-1 layer of which the bottom plate 25 is part, and interconnection of portions of the metal-1 layer to other metal layers of the IC (and associated IC components) by conductive vias (not shown).

In accordance with known CMOS processing, successive oxide layers 11, 13, 15, 27, and associated metal-2 through metal-5 layer elements 19b, 19c, 19d, 19e are arranged above oxide layer 9. The metal-5 layer includes both the metal-5 layer element 19e and top plate 33. Each of those metal layers may include additional structures such as connect lines (not shown). It should be understood that this and any following discussion of particular metal layers is by way of example only and not limitation - this invention can be employed with a greater or lesser number of metal layers and the corresponding manufacturing processes. By way of non-limiting example, the top plate 33 is preferably formed in the topmost, or at least an upper, metal layer.

As shown in Fig. 1, the bottom plate 25 is preferably larger in size than the dielectric 31, and the dielectric 31 is larger than the top plate 33; this configuration will reduce or eliminate high electric fields at the corners of the top plate 33. However, if desired, the bottom and top plates 25 and 33 can be the same size, or the top plate 33 could be larger than the bottom plate 25. That is, other wall shapes are possible without departing from the invention.

As shown, conductive vias 17b, 17c, 17d and 17e electrically connect the metal layer elements 19b, 19c, 19d and 19e, forming part of an electrical guard ring (for simplicity and keeping in mind that Fig. 1 is a side cross-sectional view of a symmetrical structure, the corresponding guard ring structure on the other side of the MIM-capacitor 2 has been omitted).

As shown in Fig. 1 and discussed hereafter, the topmost oxide layer 27 is preferably thicker than the other oxide layers 9, 11, 13, 15. By way of non-limiting example, this layer can be SiO₂.

A passivating layer 29 covers and protects the topmost oxide layer 27 and the underlying structure. By way of non-limiting example, passivating layer 29 is preferably Si₃N₄ (this material provides scratch protection). Together, layers 27 and 29 form the passivation stack. Optionally, another protective layer such as Si-rich oxide could be provided between oxide layer 27 and passivating layer 29 (which is preferably always the top layer, for scratch protection).

Opening 35 extends through the passivating layer 29 and oxide layer 27 to the top plate 33. Electrical connection can be made easily to the exposed portion of the top plate 33, for example, by wire bonding (not shown) or any other suitable connection technique now known or hereafter discovered.

Because the dielectric layer 31 of the MIM-capacitor is almost as thick as the combined thickness of the oxide layers 9, 11, 13 and 15, the vertical breakdown voltage of the capacitor can be increased substantially beyond what would be possible if the capacitor was to be made by forming the upper and lower capacitor plates as parts of adjacent metallization layers, as is the case for conventional MIM-capacitors.

The foregoing discussion of this invention in the context of a CMOS device is by way of example only, and not limitation. This invention also can be employed for BiCMOS and bipolar devices.

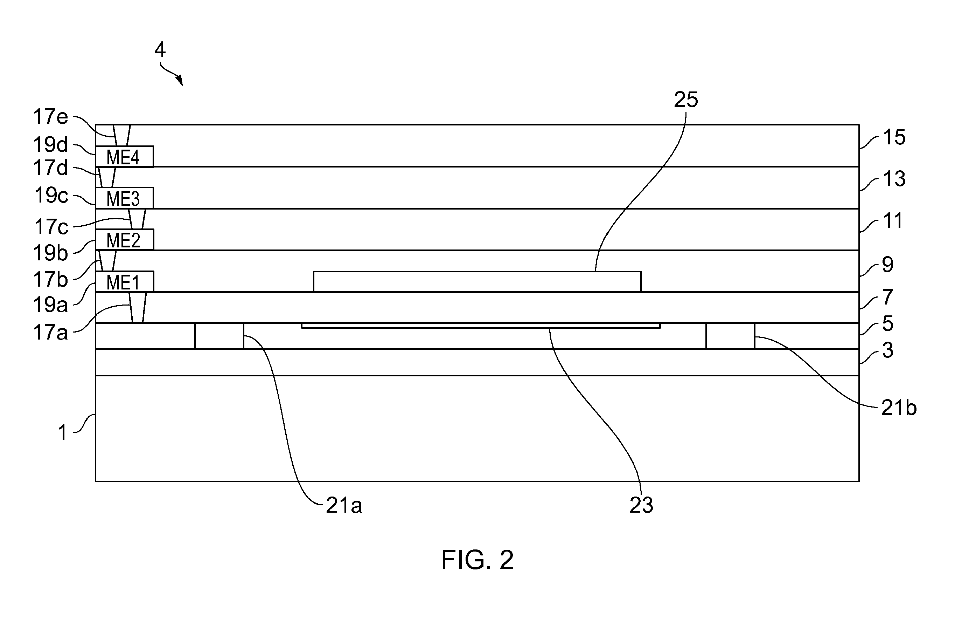

An exemplary method for manufacturing a MIM-capacitor as depicted in Fig. 1 will be discussed with reference to Figs. 2-8.

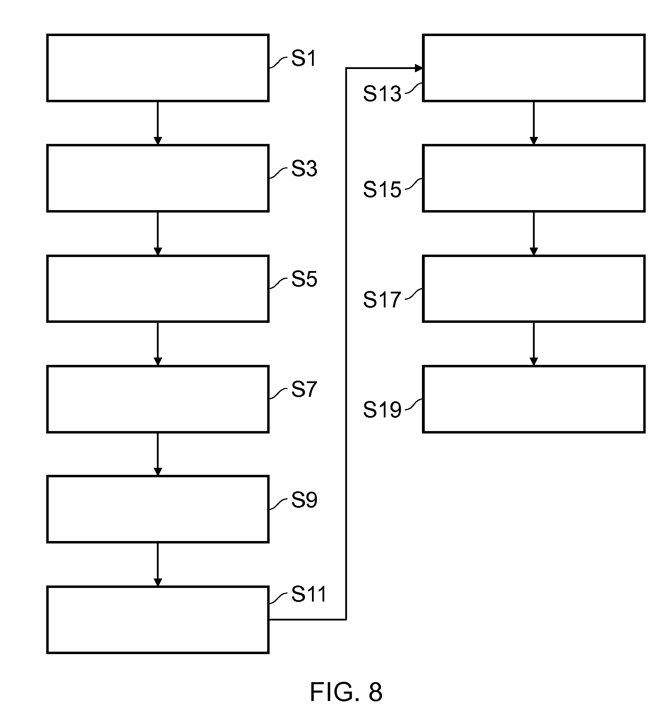

This method begins at step S1 with the assembly of the IC structure shown in Fig. 2. The partially-formed IC device 4 shown in Fig. 2 can be manufactured using a known CMOS 5-metal process. Fig. 2 shows the device after the fourth metal layer 19d has been covered by oxide layer 15; the fifth metal layer has yet to be applied, and this corresponds to step S1 of Fig. 8. Device 4 includes a buried oxide layer (BOX) 3 formed on handle wafer 1. A silicon-on-insulator substrate (SOI) 5 is formed on the BOX layer 3. Medium trench isolation (MTI) elements 21a, 21b extend through the SOI substrate 5 to the BOX layer 3, and a shallow trench isolation element 23 is formed on the SOI substrate 5, between the MTI elements 21a, 21b. Another Buried Oxide Layer (BOX) 7 is arranged above the SOI substrate 5, MTI elements 21a, 21b, and STI element 23. The metal-1 layer, which includes metal 1 layer element 19a and bottom plate 25, is are arranged on the BOX layer 7, and the metal 1 layer element 19a is in electrical communication with SOI substrate 5 through via 17, formed in BOX layer 7. The metal-1 layer is covered by oxide layer 9. Oxide layer 9 is located beneath successive oxide layers 11, 13, 15, 27, and associated metal layer elements (metal-2 through metal-4) 19b, 19c, 19d. Conductive vias 17b, 17c, 17d and 17e are provided for interlayer electrical connection.

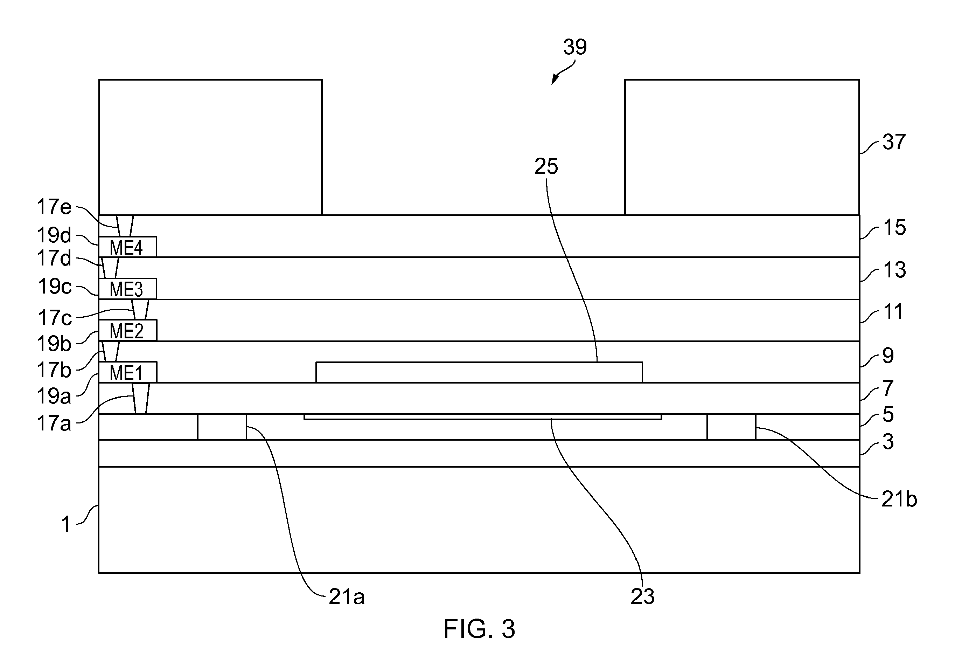

Next, as shown in Fig. 3, and corresponding to step S3 of Fig. 8, a layer of etch mask material 37 made from suitable resist is applied over the oxide layer 15 and patterned to define an opening 39 in the region where the MIM-capacitor is to be formed.

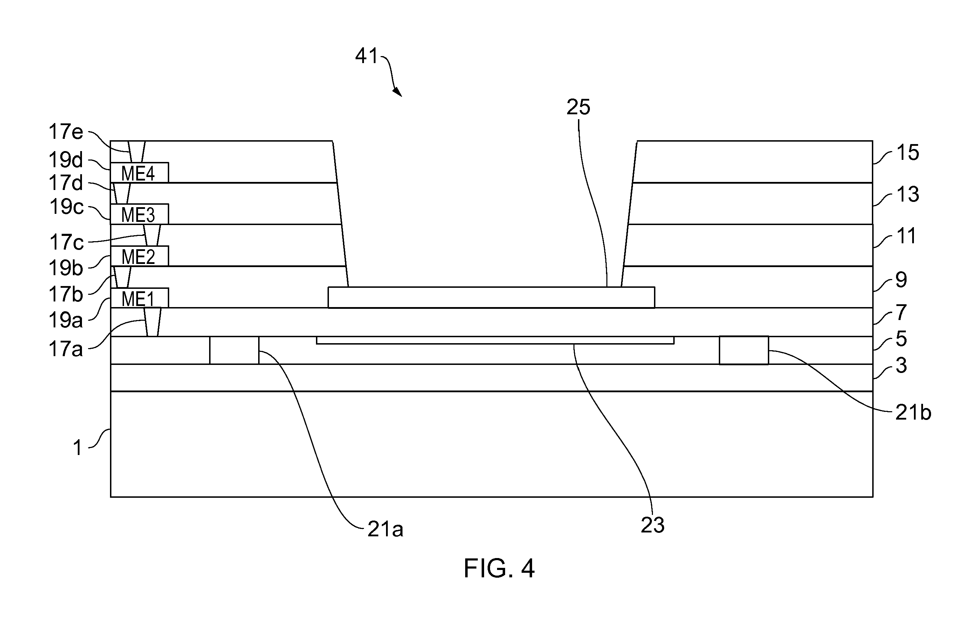

In step S5, selective etching of the workpiece, preferably dry etching, is performed, leading to the structure shown in Fig. 4. By way of non-limiting example, SiO₂ dry etching can be employed. The etching in step S5 has removed both the etch mask material 37 and the regions of oxide layers 9, 11, 13 and 15 not covered by the etch mask material 37 (any portions of the metal-1 through metal-4 layers in the etched volume also would be removed). In known manner, if, during the oxide etch, the process shows selectivity and leaves some etch mask material 37 (resist) after the desired regions of the oxide layers 9, 11, 13 and 15 have been removed, the residual resist can be removed using a resist strip operation (e.g., wet, dry or both). This leaves the bottom plate 25 exposed. Preferably, the etch mask material 37 and etching technique are chosen so that, during etching, the bottom plate 25 becomes exposed at the same time or slightly after the time that the masking material 37 is fully-removed, exposing the oxide layer 15.

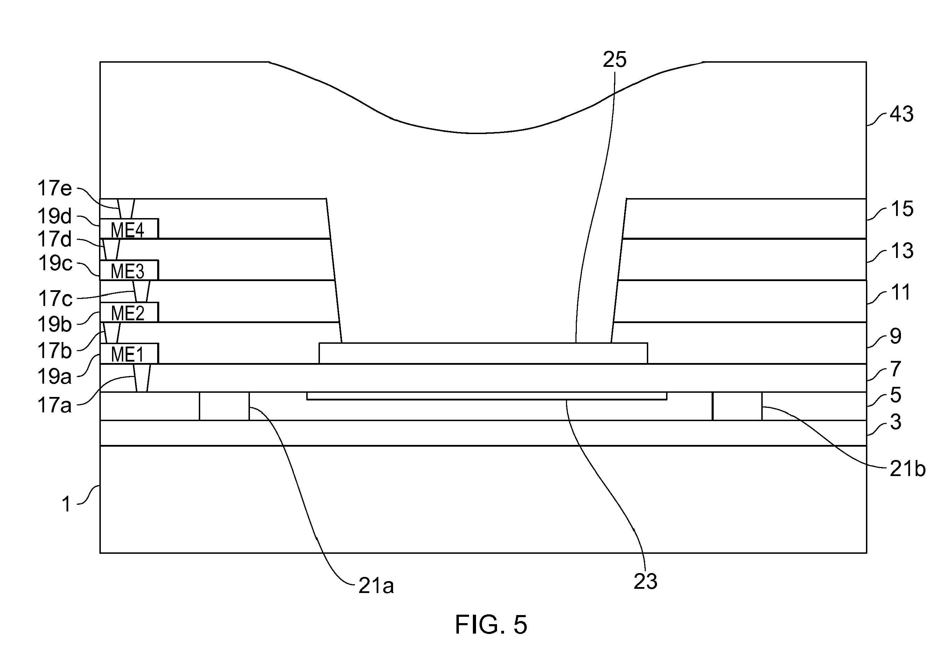

In step S7, dielectric material 43 is applied to the workpiece, covering oxide layer 15, and filling the cavity 41 that was formed by etching and covering bottom plate 25, as shown in Fig. 5.

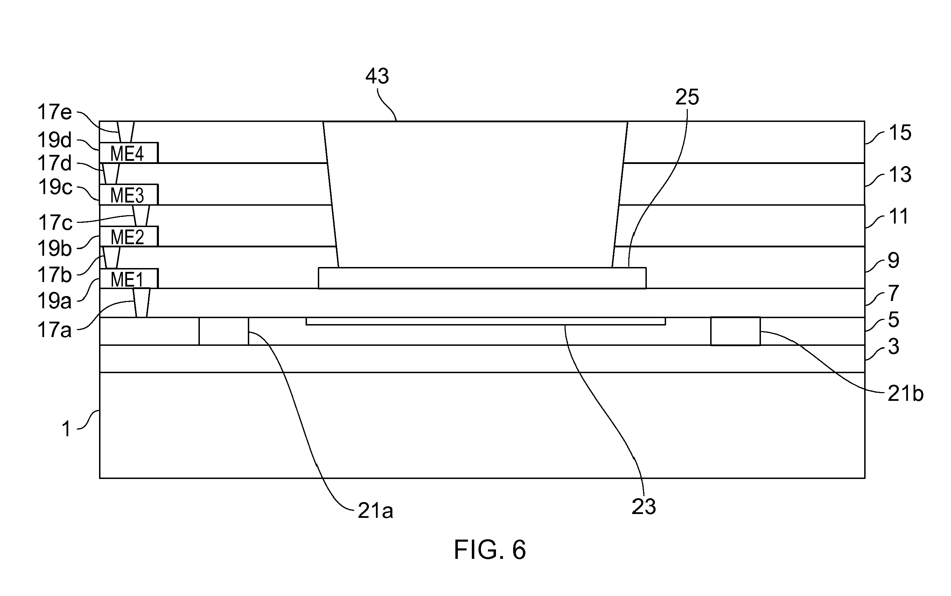

Next, in step S9, excess dielectric material 43 is removed, stopping at the via 4 level, exposing oxide layer 15 and leaving a substantially planar surface upon which additional device layers can be formed, as shown in Fig. 6. The dielectric material 43 can be removed by any suitable manufacturing technique, such as chemical mechanical polishing (CMP), such polishing being controlled to stop once the oxide layer 15 is exposed. This results in the exposed surfaces of the oxide layer 15 and dielectric layer 43 being extremely flat and lying substantially in a plane, which facilitates the application of subsequent material layers.

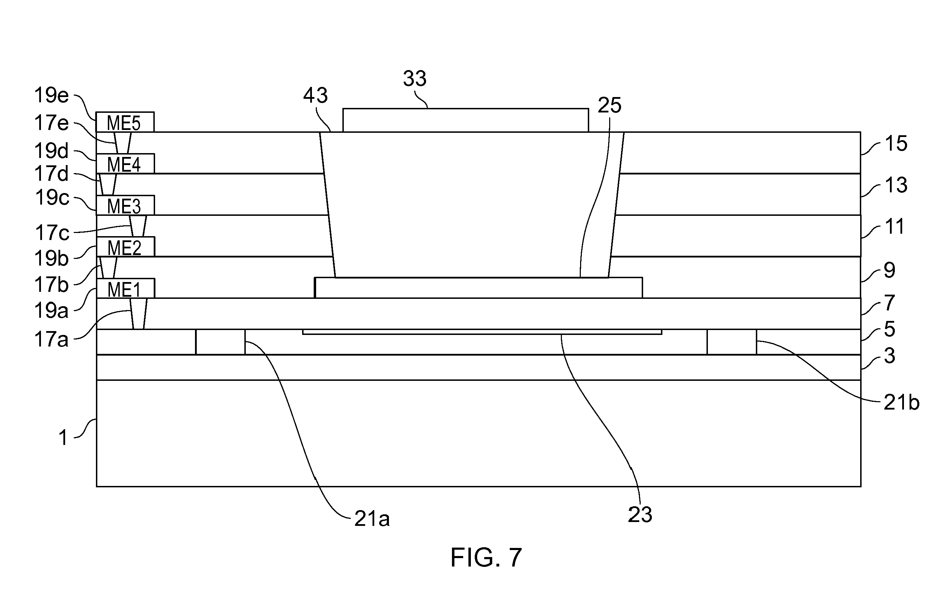

In steps S11-519, the final steps of the 5-metal CMOS process are carried out, leading to the structure shown in Fig. 7. In steps S11, the metal-5 layer is applied and patterned; both metal 5 layer element 19e and the top plate 33 of the MIM-capacitor are formed at this time, top plate 33 being located on the exposed surface of dielectric 43. Then, in step S13, oxide layer 27 is applied to cover the metal-5 layer structures (element 19e and top plate 33), and in step S15 a passivating layer 29 is applied to cover the oxide layer 27. In the same manner as step S3, masking and dry etching are respectively performed in steps S17 and S19 to expose the top plate 33 through the oxide layer 27 and the passivating layer 29, resulting in the structure shown in Fig. 1.

With reference to Fig. 8, it will be appreciate that steps S3-S9, which form the MIM-capacitor, can be performed within a conventional 5-metal CMOS process (the conventional process can include steps S1 and S11-S17).

The foregoing discussion of this invention in the context of CMOS processing is by way of example only, and not limitation. This invention also can be employed for BiCMOS and bipolar processing.

Various exemplary embodiments are described in reference to specific illustrative examples. The illustrative examples are selected to assist a person of ordinary skill in the art to form a clear understanding of, and to practice the various embodiments. However, the scope of systems, structures and devices that may be constructed to have one or more of the embodiments, and the scope of methods that may be implemented according to one or more of the embodiments, are in no way confined to the specific illustrative examples that have been presented. On the contrary, as will be readily recognized by persons of ordinary skill in the relevant arts based on this description, many other configurations, arrangements, and methods according to the various embodiments may be implemented.

To the extent positional designations such as top, bottom, upper, lower have been used in describing this invention, it will be appreciated that those designations are given with reference to the corresponding drawings, and that if the orientation of the device changes during manufacturing or operation, other positional relationships may apply instead. As described above, those positional relationships are described for clarity, not limitation.

The present invention has been described with respect to particular embodiments and with reference to certain drawings, but the invention is not limited thereto, but rather, is set forth only by the claims. The drawings described are only schematic and are non-limiting. In the drawings, for illustrative purposes, the size of various elements may be exaggerated and not drawn to a particular scale. It is intended that this invention encompasses inconsequential variations in the relevant tolerances and properties of components and modes of operation thereof. Imperfect practice of the invention is intended to be covered.

Where the term "comprising" is used in the present description and claims, it does not exclude other elements or steps. Where an indefinite or definite article is used when referring to a singular noun, e.g. "a" "an" or "the", this includes a plural of that noun unless something otherwise is specifically stated. Hence, the term "comprising" should not be interpreted as being restricted to the items listed thereafter; it does not exclude other elements or steps, and so the scope of the expression "a device comprising items A and B" should not be limited to devices consisting only of components A and B. This expression signifies that, with respect to the present invention, the only relevant components of the device are A and B.

## Claims

1. An integrated circuit, comprising:
a support;
at least three metal layers arranged above the support, said metal layers including a top metal layer having a top plate and a bottom metal layer having bottom plate;
a dielectric material disposed between said top plate and said bottom plate so as to form a capacitor; and
a plurality of oxide layers arranged above the support, said oxide layers including a top oxide layer, each said oxide layer respectively covering a corresponding said metal layer,
wherein the top oxide layer covers the top metal layer and the top oxide layer has an opening through which at least a portion of the top plate is exposed.

2. The integrated circuit of claim 1, further comprising:
a passivation layer covering the top oxide layer, the passivation layer having an opening through which the portion of the top plate is exposed.

3. The integrated circuit of claim 1, wherein the top metal layer is the topmost metal layer and the bottom metal layer is the metal-1 layer of a CMOS N-metal structure, N being the number of metal layer.

4. The integrated circuit of claim 1, wherein the top metal layer is the topmost metal layer and the bottom metal layer is the bottommost metal layer of one of a BiCMOS device structure and a bipolar device structure.

5. The integrated circuit of claim 1, wherein at least one of the following is satisfied:
the dielectric material has a different composition than the oxide layers;
the dielectric material is continuous without multiple interfaces; and
the dielectric material has an electrical breakdown strength that is greater than an electrical breakdown strength of each of the oxide layers.

6. The integrated circuit of claim 5, further comprising a silicon-on-insulator layer arranged above the buried oxide layer.

7. The integrated circuit of claim 6, further comprising at least one of a shallow trench isolation element and a medium trench isolation element arranged in the silicon-on-insulator layer.

8. The integrated circuit of claim 1, wherein a top portion of the dielectric material abuts the top plate, and, in overhead projection view, the abutting top portion of the dielectric material extends beyond the top plate.

9. The integrated circuit of claim 1, wherein a bottom portion of the dielectric material abuts the bottom plate, and, in overhead projection view, the bottom plate projects beyond the abutting bottom portion of the dielectric material.

10. A method of forming a MIM-capacitor in an integrated circuit, comprising the steps of:
providing a workpiece having a support, at least three metal layers arranged above the support, said metal layers including a bottom metal layer having bottom plate, and a plurality of oxide layers arranged above the support, said oxide layers including a top oxide layer, each said oxide layer respectively covering a corresponding said metal layer;
forming a cavity through the metal layers and the oxide layers to expose the bottom plate;
filling the cavity with a dielectric material;
applying a further metal layer above the cavity, the further metal layer including a top plate which contacts the dielectric material;
forming a further oxide layer on the further metal layer; and
forming an opening through the further oxide layer and the further metal layer to expose the top plate.

11. The method of claim 10, further comprising the step of providing a passivation layer on the further oxide layer prior to the step of forming the opening,
wherein the opening is also formed through the passivation layer.

12. The method of claim 10, further comprising, after the step of filling the cavity with the dielectric material, the step of planarizing the dielectric material.

13. The method of claim 12, wherein the planarizing is performed by CMP.

14. The method of claim 10, wherein the step of forming the cavity comprises masking and then dry etching.

15. The method of claim 10, wherein the step of forming the opening comprises masking and then dry etching.
